# EUROPEAN PATENT SPECIFICATION

(11) **EP 0 252 667 B1**
(45) Date of publication and mention of the grant of the patent: **27.03.1996**
(21) Application number: 87305782.2
(22) Date of filing: 30.06.1987
(51) Int. Cl.: H01L 21/768, C23C 16/44, H01L 21/285

(54) **Chemical vapour deposition methods**
Verfahren zum Abscheiden aus der Gasphase
Procédé de dépôt en phase vapeur

(30) Priority: 30.06.1986 JP 152922/86; 18.07.1986 JP 170336/86; 19.07.1986 JP 170281/86
(43) Date of publication of application: 13.01.1988
(73) Proprietor: NIHON SINKU GIJUTSU KABUSHIKI KAISHA, Chigasaki-shi Kanagawa-ken (JP)
(72) Inventor: Kusumoto, Yoshiro, Chigasaki-shi Kanagawa-ken (JP); Takakuwa, Kazuo, Chigasaki-shi Kanagawa-ken (JP); Ikuta, Tetsuya, Chigasaki-shi Kanagawa-ken (JP); Suzuki, Akitoshi, Chigasaki-shi Kanagawa-ken (JP); Nakayama, Izumi, Sumiredaira Hiratsuka-shi Kanagawa-ken (JP)
(74) Representative: Crisp, David Norman

(56) References cited:
- EP-A- 0 184 352
- EP-A- 0 254 651
- WO-A-86/06755
- FR-A- 2 548 218
- US-A- 4 543 270
- JOURNAL OF THE ELECTROCHEMICAL SOCIETY, vol. 132, no. 11, November 1985, pages 2779-2784, Manchester, New Hampshire, US; Y. PAULEAU et al.: "Kinetics and mechanism of selective tungsten deposition by LPCVD"
- SOLID STATE TECHNOLOGY, vol. 28, no. 12, December 1985, pages 51-59, Port Washington, New York, US; E.K. BROADBENT et al.: "Selective tungsten processing by low pressure CVD"
- RCA REVIEW, vol. 31, no. 2, June 1970, pages 306-316; J.M. SHAW et al.: "Vapor-deposited tungsten as a metallization and interconnection material for silicon devices"
- JOURNAL OF THE ELECTROCHEMICAL SOCIETY, vol. 131, no. 6, June 1984, pages 1427-1433
- IEEE ELECTRON DEVICE LETTERS, vol. EDL-5, no. 2, February 1984, pages 32-35
- JOURNAL OF APPLIED PHYSICS, vol. 58, no. 9, 1 November 1985, pages 3573-3582
- PATENT ABSTRACTS OF JAPAN, vol. 10, no. 4 (C-322)(2061), January 9, 1986 & JP-A-60 166 032

## Description

This invention relates to the selective deposition of a metal on selected areas of a wafer, e.g. a semiconductor wafer, by chemical vapour deposition (CVD).

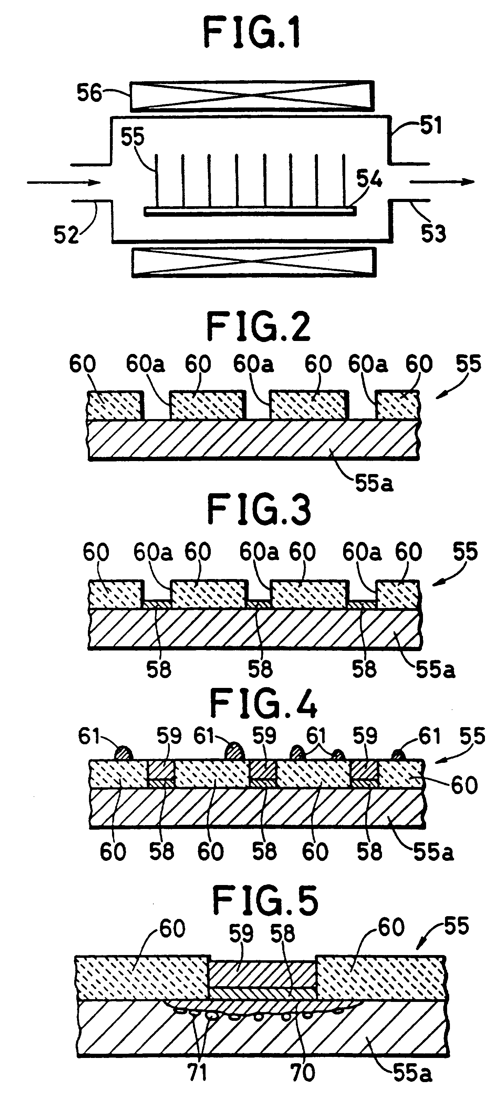

An apparatus used in a previously-proposed CVD method is shown in Figure 1 of the accompanying drawings. Referring to Figure 1, an inlet 52 and an outlet 53 are provided in respective side walls of a horizontal reaction chamber 51 which can be evacuated. A wafer holding plate 54 is horizontally arranged in reaction chamber 5. A plurality of wafers 55 are vertically held at constant spacing by the wafer holding plate 54. An electrical heater 56 is arranged around the reaction chamber 51.

A gas containing, in vapour form, a vapourisable compound of the metal to be deposited, such as tungsten hexafluoride (WF₆), and a reducing gas, such as hydrogen (H₂), are introduced into the reaction chamber 51 through the inlet 52 and exhausted via the outlet 53. The electrical heater 56 heats the reaction chamber 51 and the temperature of the inner wall of the reaction chamber 51 rises. The heat from the inner wall is transmitted through the reaction gases WF₆ and H₂ to the wafers 55. The wafers 55 are thus heated, and the reaction gases WF₆ and H₂ chemically react on the wafers 55. Metallic films are formed on the wafers 55. The reactor used in that type of process is termed a "hot wall" reactor.

Figure 2 of the accompanying drawings shows in detail, the construction of the wafer 55. Referring to Figure 2 an insulating film 60 of SiO₂ is formed on the conductive substrate 55a of the wafer 55, with through holes 60a formed in the insulating film 60 to expose the substrate 55a. During the initial stages of the CVD process the following reaction takes place on the surface of the substrate (55a): $\text{WF₆ + 3/2 Si → 3/2 SiF₄ + W}$and, as shown in Figure 3 of the accompanying drawings, an initial metallic film 58 rapidly forms on the surface of the substrate 55a in the through holes 60a.

In the subsequent stages of the CVD process the chemical reactions represented by formulae (2) and (3) then take place preferentially on the surface of the initial deposit (58) so that subsequent metal films (59) are deposited on top of the initial film (58) as shown in Figure 4. $\text{3H₂ → 6H}$$\text{WF₆ + 6H → 6HF + W}$

Generally, the growth rate G of the deposited metal film 59 can be expressed by the following equation:${\text{G = A[H}}_{\text{2}} {\text{]}}^{\text{½}} \text{exp (-Ea/kTm)}$ where A represents a positive constant, [H₂] is the hydrogen concentration, Ea is the activation energy, k is Boltzmann's constant, and Tm is the surface temperature of the growing metallic film. Thus, the growth rate G of the deposited film increases with the surface temperature Tm.

In the above-described CVD method, the surface temperature Tm of the growing metallic films 58,59 in the through holes 60a and the surface temperature Ti of the insulating film 60 are nearly equal. Moreover, the insulating film surface temperature Ti increases with the metallic film surface temperature Tm with the result that, at high deposition temperatures, metallic films 58,59 of W are formed not only in the through holes 60a, but unwanted and disadvantageous metallic nucleations 61 also occur on the insulating film 60, as shown in Figure 4.

Also, in the growing process and as shown in Figure 5, the initial film (58) of metal formed by CVD directly onto the surface of the wafer substrate encroaches the interface between the substrate 55a (which may generally be of silicon) and the insulating film 60. Thus, an encroachment 70 is formed as shown in Fig. 4 which, in some cases, may also contain voids 71 in the surface of the substrate.

Such encroachment is believed to be promoted by turbulent flow of the reaction gases or natural convection in the vicinity of the wafer 55. However, the only internal control parameters for the method are the pressure and flow rate of the reaction gas. Accordingly, it is not possible to control the turbulent flow and natural convection from the outside, and the encroachment and voids cannot be suppressed by these means. Thus, the previously-proposed hot wall reactor method has problems with reproducibility, controllability and uniformity over a wide range of pressure and flow rates.

Additionally in that type of method the reaction gas diffuses throughout the whole of the reaction chamber so that deposits also occur on the inner walls of the reaction chamber and on the inspection window. Moreover additional problems arise from the fact that dust particles are produced in the reaction chamber and appear as impurities in the deposited metal film.

Film formation at low temperature and low concentration has been considered as a way of suppressing the encroachment and voids. However, the growing rate becomes unacceptably low, for example tens of angstroms per minute (Å/min). (Broadkent Metal. J. Electrochem. Soc. 131, (42) (1984); Blower. WMIC (1985)). As an example, about two hours are required for filling a through or contact hole of 1µm depth, under these conditions.

In an intervening publication, WO86/06755, falling within the terms of Article 54(3)EPC, a method is disclosed for the selective chemical vapour deposition of a metal on metal and semiconductive surfaces of a substrate, e.g. a silicon wafer, by placing the wafer on a wafer support in an elongated reactor, passing a gaseous reaction mixture through the reactor and across the surface of the wafer, and heating the wafer to cause the decomposition of the metal-containing component of the gaseous reaction mixture and the selective deposition of that metal on the metal or semiconductor surfaces of the wafer in preference to the insulating surfaces. A variety of means are disclosed for heating the wafer, including resistance heating of the wafer support member, radio frequency induction heating of a susceptor which then heats the wafer by radiant energy, and direct heating of the wafer by exposure to a radiant energy source emitting radiant energy in the visible and ultra-violet region or the spectrum including radiation of a wavelength of 1 micrometer or less. In preferred examples, but not in the comparative examples elaborate measures are taken to isolate the wafer from undesirable impinging radiation and especially impinging undesirable infrared radiation.

The reaction kinetics involved in the selective deposition of tungsten by low-pressure CVD are discussed in detail in J. Electrochem. Soc., 131, No. 6, 1427-1433 (1984) and in Solid State Technology, 28, No. 12, 51-59 (1985) and both show the dependence of the rate of growth of CVD tungsten films on, inter alia, temperature, pressure and film thickness.

It is known from JP-A-60 166 032 to carry out a photochemical deposition method by passing a photochemically reactive gas across the surface of a substrate under conditions of laminar flow and irradiating the gas from an external source to effect the photochemical deposition of the desired deposit on the surface of the substrate. In that case it is known to introduce a stream of inert gas through the reactor in parallel with the reactive gas stream to shield the internal walls of the reactor, and particularly the window through which the radiation enters the reactor, from the reactive gas. That method relies on the chemical decomposition of the gas not thermal.

Lastly, in another intervening publication with an earlier priority date, EP-A-0254651, falling within the terms of Article 54(3) EPC, a CVD method and apparatus is described having many of the characteristic features of the present invention. In particular, in EP-A-0254651, there is disclosed a CVD method in which a mixture of reaction gases is introduced into a reactor in a direction which is substantially parallel to the surface of one or more wafers supported in the reactor on a wafer holder, and so that the reaction gas mixture flows across the surface of the wafer(s) essentially under conditions of laminar flow. Additionally an inert gas stream is introduced downwardly into the reactor perpendicularly to the flow of reaction gas downwardly onto the wafer. But in that case the wafers are heated by a resistance heater incorporated into the wafer holder.

In accordance with a first aspect of the present invention a CVD method is provided for the selective deposit of a metal on a wafer, e.g. a silicon wafer, which provides good selectivity of the deposit, and increases the rate at which the deposit forms, thus enabling wafers to be produced with formation of the metallic film in the through hole(s) only with suppression of the formation of encroachments and voids , and at improved production rates.

Moreover the method ensures that the contamination of the walls of the reactor and the formation of dust is reduced.

In this first aspect of the present invention, a reactor is used to effect the selective chemical vapour phase deposition of a metal, for example, tungsten, on wafers of the type described with reference to Figure 2, i.e. directly onto the surface of the semi-conductor, e.g. silicon, substrate which is exposed by the through holes 60a in the insulating layer 60. This selective deposition is achieved by placing the wafer on a support in the reaction chamber of a reactor, evacuating the chamber, passing the reaction gas mixture through the reaction chamber and across the surface of the wafer under conditions of laminar flow, and irradiating the wafer with infrared radiation from an internal or external infrared lamp. In that way an initial film of metal is deposited directly onto the surface of the substrate. That initial film is then preferentially heated by the infrared radiation by virtue of the different infrared absorption of the initial film compared with the surrounding insulating layer, so that the deposit continues. During the reaction the stream of reaction gas is maintained in contact with the wafer and away from the internal surfaces of the reactor by injecting a stream containing an inert gas into the reactor in a direction perpendicular to the direction of flow of the reaction gas and perpendicularly to the surface of the wafer, thereby deflecting the stream of reaction gas into contact with the surface of the wafer and substantially preventing diffusion of the reaction gas upwardly in the reactor. In that way dust formation is minimised as are deposits on the internal surfaces of the reactor.

In a modified version of the above method, the wafer is heated by means of a resistance heater incorporated into the wafer holder, rather than by means of an infrared lamp.

In yet another variant, the wafer is supported on a holder that is transparent to infrared radiation and is heated by an internal or external infrared lamp that directs infrared radiation onto the wafer(s) through the holder.

Thus the present invention provides CVD methods in which an initial metallic film is directly deposited in the through holes of the insulating film and on the surface of the substrate exposed by those through holes, followed by one or more further layers, with good quality and with good selective formation of the metallic film and wherein the creation of dust particles is prevented, so that the inner wall of the reaction chamber and the observation window are protected from contamination.

The invention will now be described by way of example with reference to the accompanying drawings, in which:
Figure 1 is a schematic cross-sectional view of a CVD apparatus according to the prior art;
Figure 2 is an enlarged cross-sectional view of a part of a wafer arranged in the CVD apparatus of Figure 1;
Figure 3 is an enlarged partial cross-sectional view of the wafer shown in Figures 1 and showing the initial CVD deposit;
Figure 4 is an enlarged partial cross-sectional view of the wafer shown in Figure 1 and showing the complete build-up of the CVD deposit;
Figure 5 is a further enlargement of part of the wafer and showing the encroachment of the deposit into the substrate;
Figure 6 is a schematic cross-sectional view of a CVD apparatus for use in accordance with a first embodiment of the present invention;
Figure 7 is an enlarged cross-sectional view of the wafer arranged in the apparatus shown in Figure 6;
Figures 8 and 9 are enlarged cross-sectional views of the wafer shown in Figure 7 and showing the build-up of the CVD deposit;
Figure 10 is a graph explaining the CVD method which forms the first aspect of the present invention;
Figures 11A to 11C are schematic cross-sectional views of the apparatus shown in Figure 6 for explaining the gas flow patterns utilised in accordance with the first aspect of the present invention;
Figures 12 and 13 are enlarged cross-sectional views of alternative wafer constructions;
Figures 14 to 18 are schematic cross-sectional views of alternative CVD apparatus usable in accordance with the present invention;
Figure 19 is a cross-sectional view taken along the line XIX-XIX in Figure 18;
Figure 20 is a cross-sectional view of yet another CVD apparatus usable in accordance with the present invention;
Figure 21 is a front view of a modification to the gas inlet of the apparatus shown in Figure 6; and
Figure 22 is a front view of another modification to the gas inlet of the apparatus shown in Figure 6.

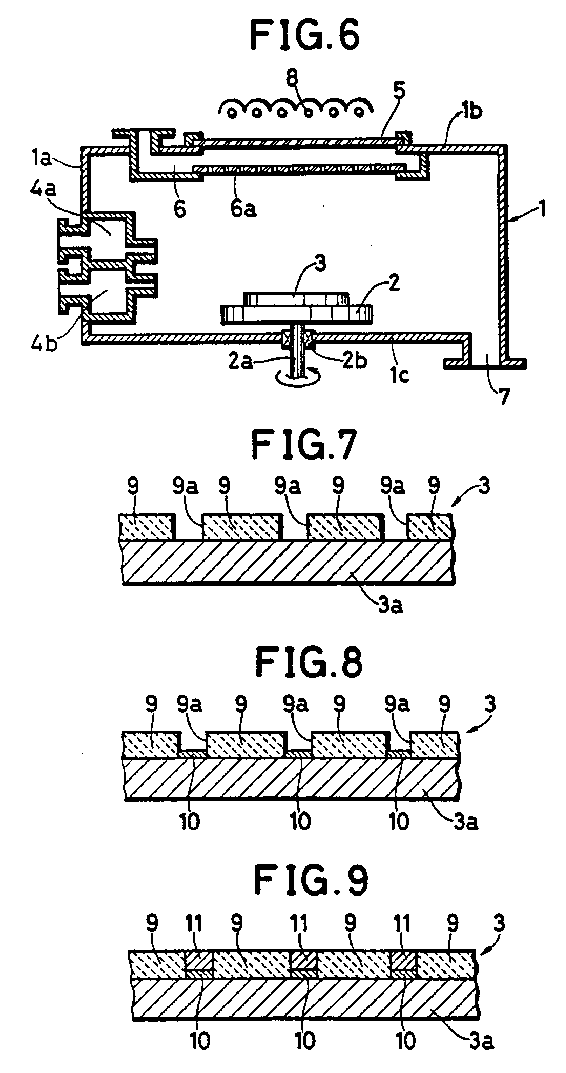

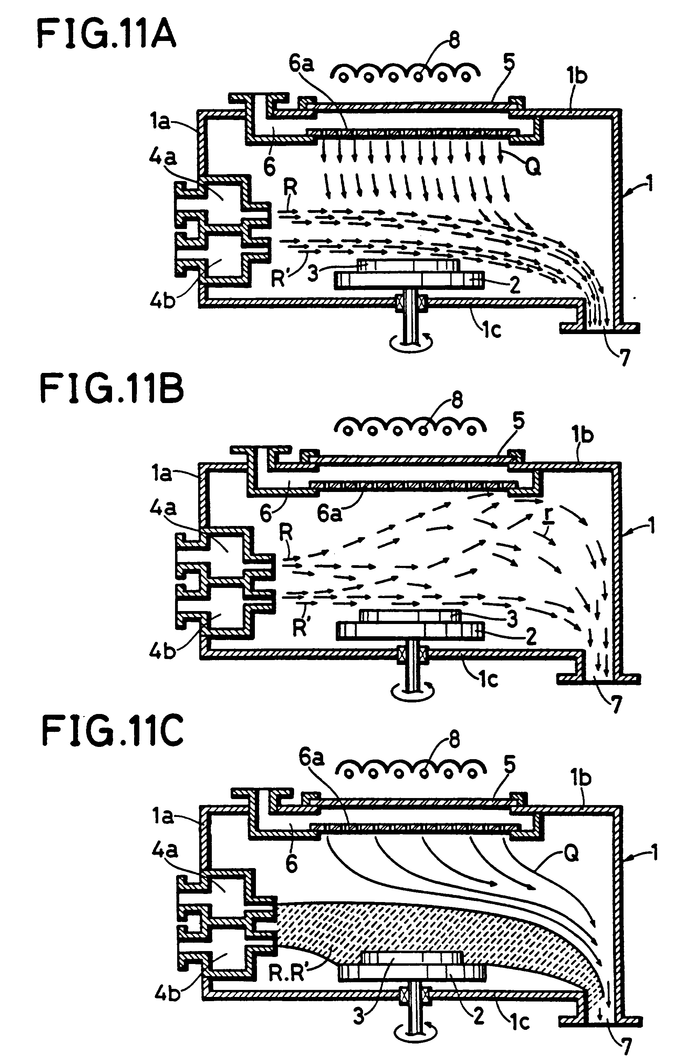

Figures 1 to 4, which relate to the prior art, have already been described. Referring now to Figure 6 which is a schematic view of a CVD apparatus for use in accordance with the first aspect of the present invention, this apparatus comprises a wafer holder 2 rotatably arranged in a pressure-reduced reaction chamber 1. A wafer 3 is held on the wafer holder 2. A shaft 2a is fixed to the wafer holder 2, and is rotatably and fluid-tightly supported by a bearing 2b which is fixed to a bottom wall 1c of the reaction chamber 1.

Gas inlets 4a and 4b having respective slit-like openings are arranged in one side wall 1a of the reaction chamber 1. A reducing gas, such as H₂, is introduced into the reaction chamber 1 through the inlet 4a, whilst the gas containing the metal to be deposited in the form of a vapourised compound such as WF₆, is introduced through the inlet 4b. The H₂ gas and WF₆ gas together flow across the surface of the wafer 3 under essentially laminar flow conditions promoted by the slit-like inlets 4a and 4b.

A transparent quartz glass plate 5 and an inert gas inlet 6 are mounted in an upper wall 1b of the reaction chamber 1. Forming part of the inert gas inlet 6 and positioned directly under the transparent quartz glass plate 5 is a perforated gas distribution plate 6a, likewise constructed of quartz, and through which an inert gas such as Ar can be introduced downwardly into the reaction chamber 1 in a direction substantially perpendicular to the stream of the H₂ and WF₆ gases. In this way the H₂ and WF₆ gases are deflected downwardly into contact with the wafer and are prevented from diffusing throughout the rest of the reactor, this gas flow pattern being illustrated more clearly in Figures 11A and 11C.

The H₂, WF₆ and Ar gases are exhausted from the reaction chamber 1 through the gas outlet 7.

A source of infrared radiation such as a lamp 8, is arranged directly above the transparent quartz glass plate 5, outside the reaction chamber 1, to provide infrared radiation impinging directly onto the surface of the wafer 3 through the transparent quartz glass plate 5 and the gas distribution plate 6a.

A CVD method using the above-described apparatus will now be described with reference to Figures 7 to 14.

Referring firstly to Figure 7, an insulating film 9 of SiO₂ is deposited on a substrate 3a of Si, and through holes or contact holes 9a are formed in the insulating film 9. The wafer 3 of Figure 7 is then mounted and held on the wafer holder 2 inside the reaction chamber 1.

H₂ reducing gas and the reactive metal-containing gas, WF₆, are introduced into the evacuated reaction chamber 1 through the gas inlets 4a and 4b. Simultaneously the wafer holder 2 supporting the wafers 3 is rotated, and Ar gas is introduced downwardly into the reaction chamber through the gas distribution plate 6a.

Infrared radiation from the infrared lamp 8 is directed on to the surface of the wafer 3 through the transparent quartz glass plate 5 and the transparent gas-distribution plate 6a. Preferably the infrared radiation has a maximum intensity at wavelengths in the range 1.1 to 3 µm.

The infrared absorption rate of silicon is low for wavelengths greater than 1.1 µm, the infrared absorption rate of SiO₂ is low for wavelengths less than 3 µm.

An initial reaction takes place at the exposed surface of the substrate 3a exposed by the through holes 9a as represented by the formula (5), in the same manner as in the conventional CVD method : $\text{WF₆ + 3/2Si → 3/2 SiF₄ + W}$

Thus first metallic films 10 of W are deposited on the surface of the substrate 3a in the through holes 9a in the insulating layer, as shown in Figure 8. When this initial film has grown to a certain depth, generally smaller than about 1000Å, that initial reaction automatically stops, but since the infrared absorption rate of the initially deposited tungsten film 10 is higher than that of either the silicon substrate 3a or the insulation layer 9 of SiO₂ over the whole wavelength range of 1.1 to 3µm, the deposited tungsten film 10 is preferentially heated by preferential absorption of the infrared radiation from the infrared lamp 8, to a temperature that is higher than that of the insulating film 9 of SiO₂.

As a result the reactions represented by the following formulae (6) and (7) are effected only on the surfaces of the initially deposited metallic film 10, thereby to effect the deposit thereon a further layer 11 of tungsten, as shown in Figure 9 virtually without any nucleation formation on the insulating film 9 of SiO₂: $\text{3H₂ → 6H}$$\text{WF₆ + 6H → 6HF + W}$

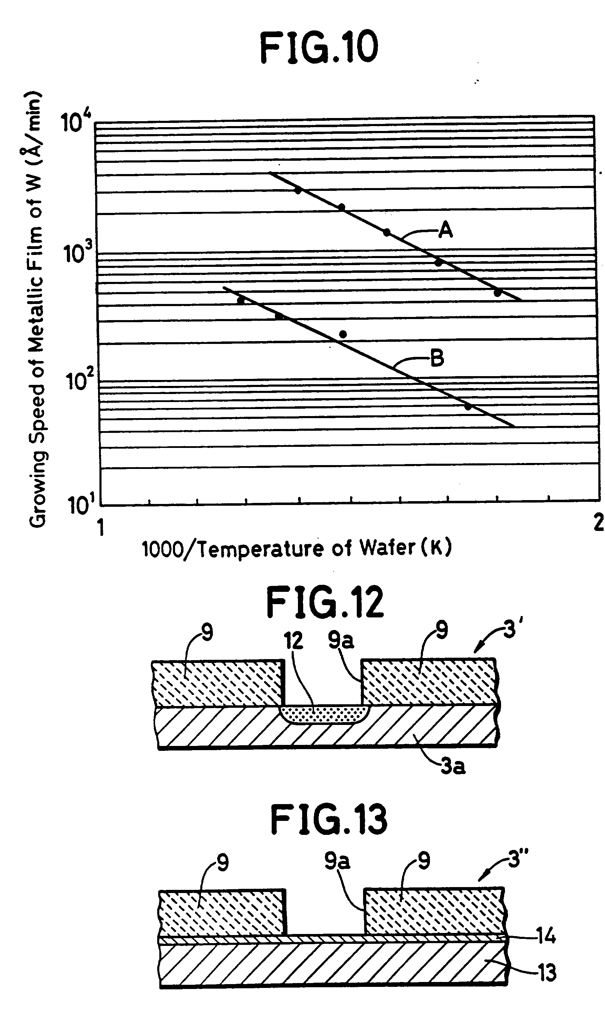

Thus, according to this first embodiment, the first metallic films 10 of W are deposited on the substrate 3a in the through holes 9a of the insulating film 9 in the initial stage. Then, the above chemical reactions are effected only the first metallic films 10, since the first metallic films 10 and the insulating film 9 of SiO₂ are heated by the infrared lamp 8 so as to have a temperature difference. Thus, the metallic films of W are formed only in the through holes 9a of the insulating film 9. As shown in Figure 10, the growth rate of W film represented by a reference A is higher in this embodiment than the growth rate of W film represented by a reference B according to the previously-proposed method.

Turning now in more detail to Figures 11A to 11C which illustrate the first aspect of the invention, i.e. the gas flow pattern through the reactor, H₂ gas is introduced into the space S of the reaction chamber 1, through the slit-like nozzle 4a, and its gas flow is represented by a reference R in Figures 11A to 11C. Simultaneously a reactive gas stream containing vapourised WF₆ is introduced into the space S of the reaction chamber 1, through the slit-like nozzle 4b, the WF₆ gas flow being represented by a reference R' in Figures 11A to 11C. Because of the elongated slit-like nozzles 4a and 4b, thee H₂ gas stream and the WF₆ gas stream are introduced into the reactor as two essentially planar, two-dimensional gas streams parallel to the surface of the wafer 3. At the same time an inert gas, such as Ar, is introduced downwardly into the reactor from the inert gas distribution plate 6a, its gas flow being represented by a reference Q in Figures 11A to 11C. The gas flow rates R, R' and Q are externally controlled so that the flow rate of the inert gas Q is, for example, three times the flow rate of the reaction gases R and R'.

As will be understood from Figure 11A, the flow of the reaction gases R, R' is restricted to the vicinity of the wafer 3, and pass across the surface of the wafer under essentially laminar flow conditions. This is achieved by means of the inert gas Q which contains the reaction gas flows R, R' from above. That stabilising operation has been confirmed by computer simulation, and by practical experiments using titanium tetrachloride to visualise the gas flow pattern.

The flow R, R' of the reaction gases is a macroscopically limited laminar flow, as shown by the hatched area in Figure 11C, the extent or range of which is controlled by the flow of the inert gas Q.

As will be understood from Figure 11B, if there is no inert gas allow Q the reaction gases R, R' will diffuse widely through the region r under turbulent flow conditions, thus contaminating the inner wall of the reaction chamber and the inspection window, as in the previously-proposed method.

However, according to the present invention, the reaction gas flows R and R' are stabilised and limited to the vicinity of the wafer 3 as shown in Figure 11A or Figure 11C. Accordingly, the inner wall of the reaction chamber and the inspection window are protected from contamination. The quality of the metal film 11 formed on the wafer 3 is thus improved, and the formation of dust particles reduced. Also when the second metal films 11 are formed on the first metal film 10 (as shown in Figure 9), the encroachment 70 and the voids 71 shown in Figure 5 can almost entirely be prevented from growing under the first metal films 10 or the insulating film 9, in contrast to the previously-proposed method. Accordingly, the yield rate of semiconductor devices made using the wafer 3 can be improved.

Since the reaction gas flows R and R' are made laminar, the method according to this embodiment is superior in controllability and reproducibility. The growth rate distribution of the second metallic film 11 formed on the first metallic film 10 in the wafer 3, and the depth of the encroachment can be controlled with the flow rate Q of the inert gas.

A theoretical ground for the effects of the gas flows according to this embodiment will now be discussed. There are unclear points concerning the influence of the reaction gas flows on the encroachment. However, the following explanation may be possible.

The silicon reduction reaction, represented by the formula: $\text{WF₆ + 3/2Si → W + 3/2SiF₄}$ is effected also after the initial stage, at which the first encroachment occurs. Therefore, the silicon reduction reaction should spontaneously stop when the silicon substrate in the through holes is covered with the initial deposit 10.

It is considered that the reaction gas is supplied onto the wafer 3 through the gaps between the sides of the metallic films 10 and 11 and the sides of the through holes 9a of the insulating film 9, and slight gaps among the numerous crystal grains of the metallic films 10 and 11. In order to promote the silicon reduction at the interface between the metallic film and the silicon substrate, the reaction product (SiF₄) should be effectively discharged into the space in the reaction chamber. When a turbulent flow region exists near the surface of the wafer, the reaction product is rapidly discharged and diffused outwardly through the above-described gaps due to pumping operation of the turbulent diffusion. However, when the whole surface of the wafer is covered with the laminar flow, the reaction product is discharged outwardly only by a molecular diffusion phenomenon. When the gaps are sufficiently narrow, the discharging speed is negligibly small in comparison with the discharging due to the turbulent diffusion. It will be understood from the above that the gas flow control in the vicinity of the surface of the wafer has considerable influence on the encroachment.

Comparison experiments were made under the same growth temperature, total pressure and partial pressure of the reaction gas in the two cases when the reaction gas flows R and R' are made laminar by the inert gas flow Q, and when the reaction gas flows R and R' are not made laminar. Tungsten hexafluoride WF₆ and hydrogen H₂ were used as the reaction gases, and argon Ar was used as the inert gas, as above-described.

The tungsten film was formed to a depth of about 7000 Å in the through hole, at a growth temperature of 400°C under a total pressure of about 93 Pa (0.7 Torr). According to observation of the crosssection of the resulting wafer by a scanning electron microscope, the horizontal and vertical dimensions of the encroachment were larger than 3200Å and 2000Å respectively in the case when the inert gas was not used, while they were smaller than 400Å and 800Å respectively in the case when the inert gas was used. Further, from the film formation experiments under the widely different conditions, it was confirmed that the suppressing effect of the encroachment by the above-described laminarisation functions was a parameter independent of the growth temperature and pressure.

In the above-described embodiment, H₂ and WF₆ are used respectively for the reduction gas and the gas containing a metallic element. However, the described method is not limited to these particular gases. For example, MoF₆, TaF₅, CrF₄, TiF₄, TiCl₄, MoCl₅, WCl₆, AlCl₃ and the like may instead be used for- the metallic element containing gas. Further, in the above-described embodiment, SiO₂ is used for the insulating film 9. As an alternative, for example, an oxide such as Al₂O₃, BSG (Borosilicate glass), PSG (Phosphosilicate glass) and BPSG (Borophosphosilicate glass), a nitride such as BN or SiNₓ, or a chemical compound such as SiNₓO_{y} may be used for the insulating film, x and y representing numerals.

Further in the above embodiment, the first metallic films are made of W. Alternatively, for example, the first metallic films may be made of a different metal such as Mo, Ta, Cr, Ti, Al or an alloy of two or more of these metals (possibly including W).

Further, in the above embodiment, the substrate 3a of the wafer 3 is made of Si. However, a wafer 3' as shown in Figure 12 may be used instead of the wafer 3, such that an ionic region 12 of ions of an element belonging to the third (III) group or fifth (V) group of the periodic table is implanted into a part of the substrate 3a of Si, and that some silicon is exposed on the surface of the contact hole 9a. Alternatively, a wafer 3" as shown in Figure 13 may be used instead of the wafer 3, such that a Si film 14 is formed as the uppermost film on a substrate 13 made of material or element other than silicon. For example, the substrate 13 may be of sapphire.

Further, when the first metallic film of W grows, the silicon elements exposed on the surface of the substrate 3a may be diffused into the metallic film of W. Alternatively, when the first metallic film of Mo, Ta, Cr, Ti, or Al, or of an alloy of two or more thereof (possibly including W) grows, the silicon elements exposed on the surface of the substrate 3a may be diffused into the metallic film of such a metal or alloy.

Further in the above embodiment, the maximum intensity of the infrared lamp 8 is obtained at a wavelength between 1.1 and 3 µm. Alternatively, an infrared lamp exhibiting a maximum intensity of radiation components at a wavelength between 0.75 and 5 µm may be used.

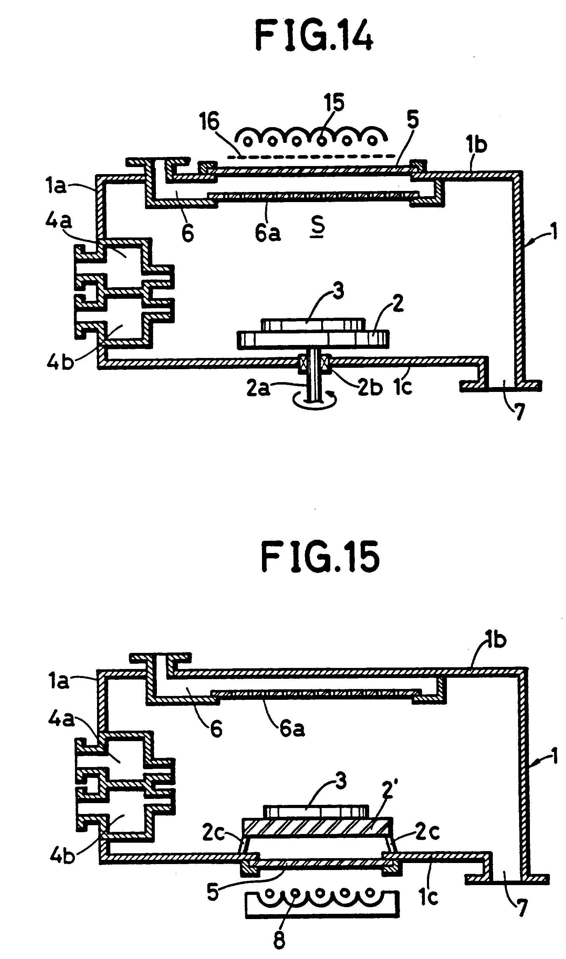

Figure 14 shows a CVD apparatus according to a second embodiment of this invention. Parts in Figure 14 which correspond to those in Figure 6 are denoted by the same reference numerals.

Referring to Figure 14, a heating source such as a lamp 15 is used with an optical filter 16 interposed between the heating lamp 15 and the transparent quartz glass plate 5. Light components passing through the optical filter 16 from the heating lamp 12 exhibit a maximum intensity at wavelengths of 0.75 to 5 µm. The same operation as described with reference to the first embodiment is performed for the wafer 3, and the same effects can be obtained for the wafer 3.

Figure 15 shows a CVD apparatus according to a third embodiment of this invention. Parts in Figure 15 which correspond to those in Figure 6 are denoted by the same reference numerals.

Referring to Figure 15, the infrared source or lamp 8 is arranged under a wafer holder 2' which is made of transparent quartz glass. The transparent quartz glass plate 5 is fixed to the bottom wall 1c in contrast to the first embodiment of Figure 6. The wafer holder 2' is fixed to the bottom wall 1c by support members 2c. The same operations as described with reference to the first embodiment are performed for the wafer 3, and the same effects can be obtained for the wafer 3.

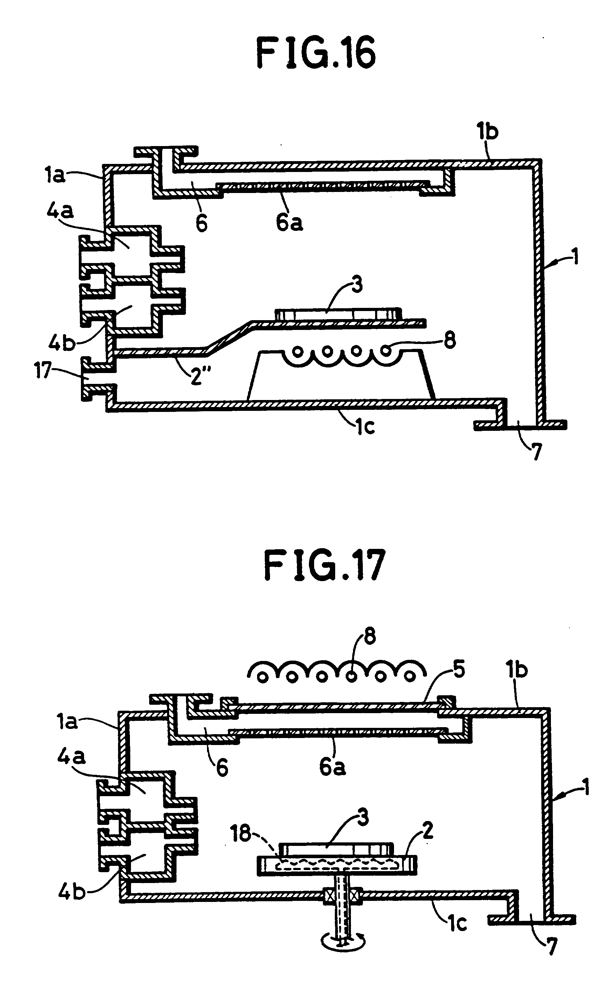

Figure 16 shows a CVD apparatus according to a fourth embodiment of this invention. Parts in Figure 16 which correspond to those in Figure 6 are denoted by the same reference numerals.

Referring to Figure 16, the infrared lamp 8 is arranged under a wafer holder 2" inside the reaction chamber 1. The wafer holder 2" is made of transparent quartz glass plate, and it is fixed to the side wall 1a of the reaction chamber 1. Further, an inert gas introducing inlet 17 is made in the side wall 1a of the reaction chamber 1. The inert gas from the inlet 17 flows through the space between the wafer holder 2" and the infrared lamp 8, and it is discharged from the outlet 7. The reaction products are prevented from adhering on to the infrared lamp 8 and the wafer holder 2" by the flow of the inert gas from the inlet 17. The same operations as described with reference to the first embodiment are performed for the wafer 3, and the same effects can be obtained for the wafer 3.

Figure 17 shows a CVD apparatus according to a fifth embodiment of this invention. Parts in Figure 17 which correspond to those in Figure 6 are denoted by the same reference numerals.

Referring to Figure 17, the wafer holder 2 is provided with a heater 18. The wafer 3 is heated also by the heater 18. The same operations as described with reference to the first embodiment are performed for the wafer 3, and the same effects can be obtained for the wafer 3.

In the above embodiments, a heating lamp or infrared lamp is used. Hereafter, embodiments without a lamp will be described, by which a wafer with high quality can also be obtained, particularly with respect to reduced encroachment and voids.

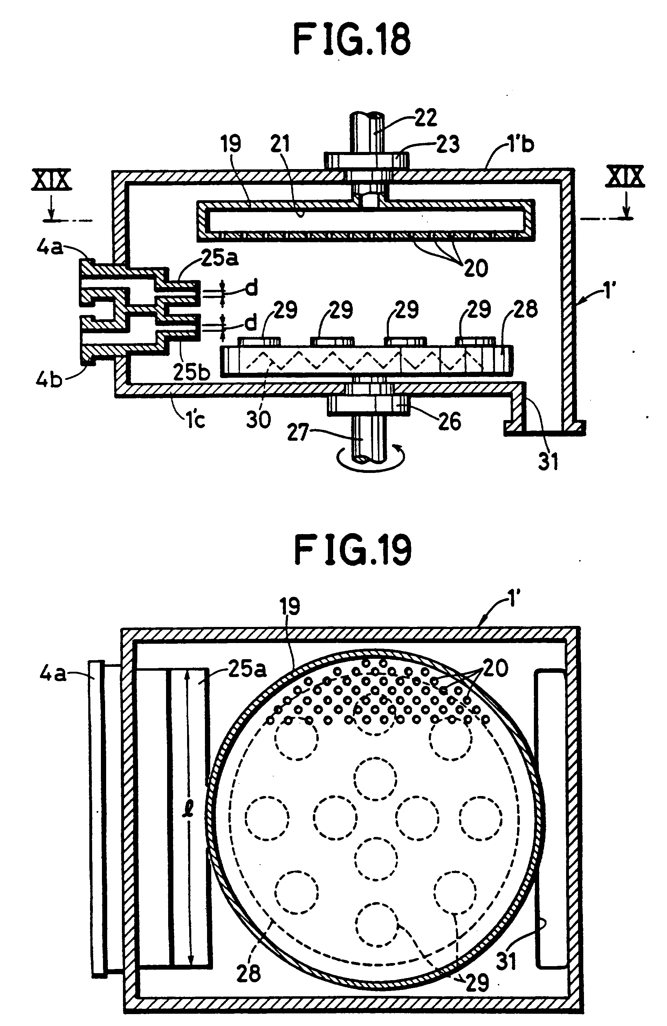

Figure 18 and Figure 19 show a CVD apparatus according to a sixth embodiment of this invention. Parts in Figures 18 and 19 which correspond to those in Figure 6 are denoted by the same reference numerals. The gas introducing portions 4a and 4b will be described in more detail in this embodiment, although they have the same construction as in Figure 6.

The gas introducing portions 4a and 4b have nozzle portions 25a and 25b with slit-like openings. Under levels of the nozzle portions 25a and 25b, a circular wafer holder 28 is rotatably arranged in a reaction chamber 1'. A rotary shaft 27 passing fluid-tightly through a seal member 26 is fixed to the centre of the wafer holder 28. The wafer holder 28 is rotated at a predetermined speed. (The wafer holder 2 in the first embodiment is similarly rotated.) A discharge outlet 31 is formed in the bottom wall 1'c of the reaction chamber 1'.

The wafer holder 28 includes a heater 30. A plurality of wafers 29 are mounted on the wafer holder 28, and they are heated by the heater 30. The wafers 29 have the same construction as the wafer 3 described in the first embodiment, that is as shown in Figure 7.

An inert gas distribution plate 19 is arranged directly above the wafer holder 28, and it has a hollow portion 21. A pipe 22 passes fluid-tightly through a seal member 23 fixed to the upper wall 1b of the reaction chamber 1', and it communicates with the hollow portion 21. An inert gas such as Ar is supplied via the pipe 22. Numerous small openings 20 are made in the inert gas distribution plate 19, through which the inert gas is ejected downwardly.

The nozzle portions 25a and 25b extend substantially in parallel with the upper surface of the wafer holder 28. Also, the slit-like openings thereof extend substantially in parallel with the upper surface of the wafer holder 28. The width d of the nozzle portions 25a and 25b is sufficiently small in comparison with the length l of the slit-like openings thereof. The reaction gases are ejected from the nozzle openings at a flow rate corresponding to a Reynolds number larger than 10. The distance between the level of the nozzle portions 25a and 25b and the surface of the wafer holder 28 is so designed as to be nearly equal to 40% of the distance between the inert gas distribution plate 19 and the upper surface of the wafer holder 28. Although the widths d of the nozzle portions 25a and 25b are in practice very small, they are exaggerated in the drawings for better clarity. The nozzle portions 25a and 25b may alternatively be made as one common nozzle portion, and the reaction gases H₂ and WF₆ may be mixed before being ejected from the one common nozzle portion.

In operation, the inert gas is ejected downwardly from the inert gas distribution plate 19, and the reaction gases are ejected horizontally from the nozzle portions 25a and 25b. The gas flow effect described with reference to the first embodiment, as shown in Figures 11A to 11C, can also be obtained in this embodiment. The second metallic film is deposited on the first metallic film with good quality, particularly with respect to encroachment and voids.

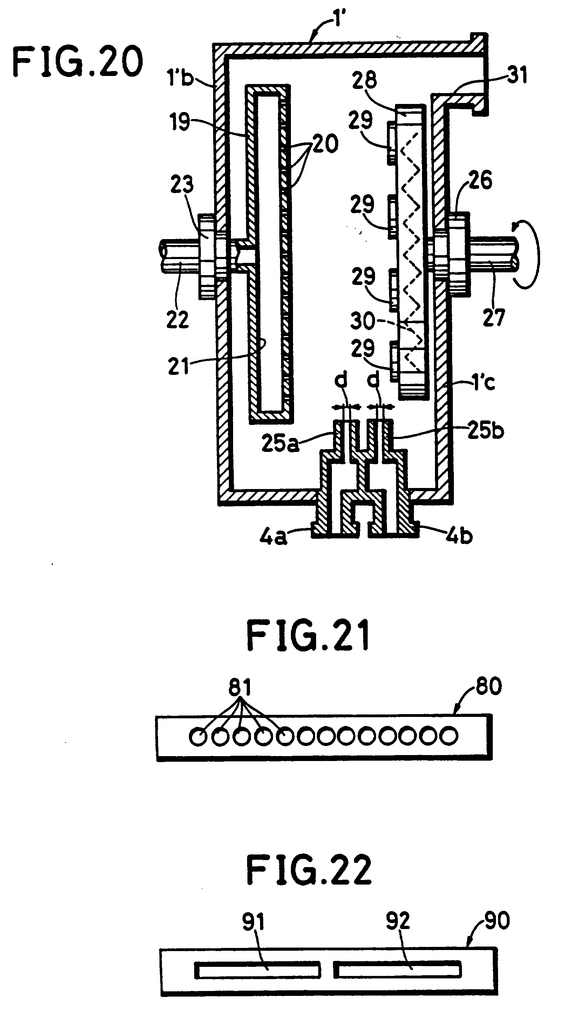

Figure 20 shows a seventh embodiment. Parts in Figure 20 which correspond to those in Figure 18 are denoted by the same reference numerals. The whole reaction chamber 1' of this embodiment is angularly displaced by 90 degrees in comparison with that of the previous embodiments.

Variations to the above-described embodiments may be made, for example as outlined in the following.

For example, in the above embodiments, the gas introducing portions 4a and 4b have slit-like openings. Instead, a flat hollow pipe 80 as shown in Figure 21 may be used. Numerous small openings 81 are provided in the front wall of the pipe 80. A mixed gas of WF₆ and H₂ is ejected from the openings 81. Alternatively, a flat hollow pipe 90 as shown in Figure 22 may be used, having two slits 91 and 92 made along the same horizontal line, in the front wall.

Further, in the embodiments of Figures 6 and Figures 14 to 17, a plate having numerous small openings is used for the inert gas distribution plate 6a. Instead, a transparent strainer with a suitable aspect ratio or a transparent honeycomb may be used.

Further in the above embodiment, inert gas is used to provide the gas flow towards the surface of the wafer. Instead, an inert gas containing a partially reactive gas may be used. In this case, it is necessary that the reactive gas should not make dust particles. For example, the reactive gas may be H₂ or O₂.

Further in the above embodiments, two gas introducing portions 4a and 4b for WF₆ and H₂, respectively, are provided. However, they may be replaced by one, and a mixed gas of WF₆ and H₂ may be introduced from one gas introducing portion.

Further, in the embodiment of Figure 17, the wafer holder 2 contains the heater 18. Instead, it may contain an infrared lamp. In that case, the infrared lamp 8 outside the reaction chamber 1 may be omitted, and the holder 2 should be made transparent.

## Claims

1. A method of selectively depositing a metal in a hole or holes (9a) on a wafer (3) and provided thereon by through hole(s) in an insulating layer (9) formed on the surface of a wafer substrate (3a), by chemical vapour deposition in a reactor by the steps of placing the wafer (3) on a wafer holder (2) in a reaction chamber (1), evacuating the reaction chamber, feeding to the evacuated reaction chamber and across the surface of the wafer a reaction gas mixture (R, R') containing a metal-containing gas and a reducing gas capable of reacting with the metal-containing gas to deposit said metal in said through hole(s), and exposing the wafer, whilst supported in said chamber on said holder, to a source of infrared radiation thereby to cause the metal to deposit substantially only in said hole(s) (9a) wherein the source of infrared radiation is an infrared lamp (8, 15), in the initial stages of the deposit the deposit of an initial thin film (10) of said metal is effected directly onto the surface of the substrate (3a) in said through holes (9a), and in the subsequent stages of the deposit, said lamp causes the preferential heating of that initially deposited film (10) so as to effect the deposit of a further layer (11) of said metal on top of the initial deposit (10) as a result of the reaction of the metal-containing gas and the reducing gas in said holes by virtue of the different infrared absorption rates of said initial thin film (10) and the surrounding insulating layer (9), and wherein further the gaseous reaction mixture (R, R') flows in the reaction chamber (1) in a direction substantially parallel to the surface of the wafer so as to provide a substantially laminar flow of reaction gas across the surface of the wafer, and wherein an inert gas stream (Q), optionally containing a partially reactive gas, is directed into the reaction chamber (1) substantially perpendicularly to the direction of flow of the reaction gas mixture (R, R') through the chamber and substantially perpendicularly toward the surface of the wafer holder (2) thereby to maintain the laminar flow of reaction gas across and in contact with the wafer(s) (3) supported on the wafer holder (2) and to substantially prevent diffusion of the reaction gas mixture upwardly in the reaction chamber.

2. A method according to claim 1, characterised in that the infrared lamp (8, 15) provides a source of infrared radiation which is most intensive in the wavelength range 0.75 to 5 µm.

3. A method according to claim 1 or 2, characterised in that the infrared lamp (8, 15) is located externally of the reaction chamber (1) and positioned to direct infrared radiation onto the wafer holder (2) via an infrared transparent window (5) located in a wall (1b) of the reaction chamber directly opposite the wafer holder (2).

4. A method according to claim 3, wherein an infrared filter (16) is positioned between the external infrared lamp (15) and said window (5), such filter serving to restrict the infrared radiation directed into the reaction chamber (1) and onto the wafer (3) supported by the wafer holder (2) to wavelengths in the range 0.75 to 5 µm.

5. A method according to claim 1 to 4, characterised in that the wafer (3) is additionally heated by a resistance heater (18) incorporated into the wafer holder (2).

6. A method of selectively depositing a metal in a hole or holes (9a) on a wafer (3) and provided thereon by through hole(s) in an insulating film (9) formed on the surface of a wafer substrate (3a), by chemical vapour deposition in a reactor by the steps of placing the wafer (3) on a wafer holder (2) in a reaction chamber (1), evacuating the reaction chamber, feeding to the evacuated reaction chamber and across the surface of the wafer a reaction gas mixture (R, R') containing a metal-containing gas and a reducing gas capable of reacting with the metal-containg gas to deposit the metal in said through hole(s), and heating the wafer, whilst supported in said chamber on said holder, thereby to deposit the metal substantially only in said hole(s) (9a) wherein, in the initial stages of the deposit, the deposit of an initial thin film (10) of said metal is effected directly onto the surface of the substrate in said through hole(s) (9a), and in the subsequent stages of the deposit, the deposit of a further layer (11) of said metal on top of the initial deposit (10) is effected as a result of the reaction of the metal-containing gas and the reducing gas in the holes, wherein the gaseous reaction mixture (R, R') flows in the reaction chamber (1) in a direction substantially parallel to the surface of the wafer so as to provide a substantially laminar flow of reaction gas across the surface of the wafer, and wherein an inert gas stream (Q), optionally containing a partially reactive gas, is directed into the reaction chamber (1) substantially perpendicularly to the direction of flow of the reaction gas mixture (R, R') through the chamber and substantially perpendicularly towards the wafer holder (2) thereby to maintain the laminar flow of reaction gas across and in contact with the wafer(s) (3) supported on the wafer holder (2) and to substantially prevent diffusion of the reaction gas mixture upwardly in the reaction chamber.

7. A method according to claim 6, characterised in that the wafer(s) (3) is or are heated by means of a resistance heater (30) incorporated into the wafer holder (2).

8. A method according to claim 6, characterised in that the wafer holder (2', 2") is transparent to infrared radiation and in that the wafer is heated by means of an infrared lamp (8, 15) positioned to direct infrared radiation onto the wafer through the holder.

9. A method according to claim 8, characterised in that the infrared lamp (8) is located externally of the reaction chamber (1) and in a position to direct infrared radiation onto the wafer through said holder and through an infrared transparent window (5) in the wall (1c) of the reaction chamber.

10. A method according to claim 8, characterised in that the infrared lamp (8) is positioned inside the reaction chamber (1).

11. A method according to claim 10, characterised in that a second inert gas stream (17) is caused to flow between the infrared lamp (8) and the wafer holder (2") to shield the infrared lamp (8) from the mixture of reaction gases (R, R').

12. A method according to any one of the preceding claims, wherein said reducing gas is H₂, and the metal-containing gas is one or more of WF₆, MoF₆, TaF₅, CrF₄, TiF₄, TiCl₄, MoCl₅, WCl₆ and AlCl₃.

13. A method according to any one of the preceding claims, wherein said insulating film (9) is one or more of SiO₂, Al₂O₃, oxides of BSG, PSG or BPSG, BN, SiNₓ, or SiNₓO_{y}.

14. A method according to claim 11, wherein the wafer substrate (3a) consists of an underlying support layer (13) having a surface film (14) of silicon deposited thereon and underlying said insulating layer (9).

15. A method according to any one of the preceding claims, wherein the wafer holder (2) is rotated during the chemical vapour phase deposition of said metal onto the wafer supported thereon.

## Patentansprüche

1. Verfahren zur selektiven Abscheidung eines Metalles in einem Loch oder in Löchern (9a) auf einem Plättchen (3) und darauf vorgesehen durch ein Durchgangsloch oder Durchgangslöcher in einer Isolierschicht (9), die auf der Oberfläche eines Plättchensubstrates (3a) ausgebildet ist, durch chemische Abscheidung aus der Dampfphase in einem Reaktor mit den Stufen, in denen man das Plättchen (3) auf einem Plättchenhalter (2) in einer Reaktionskammer (1) anordnet, die Reaktionskammer evakuiert, in die evakuierte Reaktionskammer und über die Oberfläche des Plättchens ein Reaktionsgasgemisch (R, R') einführt, das ein metallhaltiges Gas und ein reduzierendes Gas, welches mit dem metallhaltigen Gas unter Abscheidung des Metalles in dem Durchgangsloch oder den Durchgangslöchern reagieren kann, enthält, und das Plättchen, während es in der Kammer auf dem Halter gehalten wird, einer Infrarotstrahlungsquelle aussetzt, um dabei eine Abscheidung des Metalles im wesentlichen nur in dem Loch oder den Löchern (9a) zu bewirken, wobei die Infrarotstrahlungsquelle eine Infrarotlampe (8, 15) ist, in den Anfangsstufen der Abscheidung die Abscheidung eines dünnen Anfangsfilmes (10) des Metalles direkt auf der Oberfläche des Substrates (3a) in den Durchgangslöchern (9a) bewirkt wird und in den anschließenden Stufen der Abscheidung die Lampe das bevorzugte Erwärmen jenes anfangs abgeschiedenen Filmes (10) bewirkt wird, um die Abscheidung einer weiteren Schicht (11) des Metalles über der Anfangsabscheidung (10) als ein Ergebnis der Umsetzung des metallhaltigen Gases und des reduzierenden Gases in den Löchern aufgrund der unterschiedlichen Infrarotabsorptionsgeschwindigkeiten des dünnen Anfangsfilmes (10) und der umgebenden Isolierschicht (9) zu bewirken, und wobei weiterhin das gasförmige Reaktionsgemisch (R, R') in die Reaktionskammer (1) in einer Richtung im wesentlichen parallel zu der Oberfläche des Plättchens strömt, um so einen im wesentlichen laminaren Fluß des Reaktionsgases über die Oberfläche des Plättchens zu bekommen, und wobei ein Inertgasstrom (Q), der gegebenenfalls ein teilreaktives Gas enthält, in die Reaktionskammer (1) im wesentlichen senkrecht zu der Strömungsrichtung des Reaktionsgasgemisches (R, R') durch die Kammer und im wesentlichen senkrecht zu der Oberfläche des Plättchenhalters (2) gerichtet wird, um dabei den laminaren Reaktionsgasfluß über das oder die Plättchen (3), die auf dem Plättchenhalter (2) gehalten werden, aufrechtzuerhalten und im wesentlichen eine Diffusion des Reaktionsgasgemisches aufwärts in der Reaktionskammer zu verhindern.

2. Verfahren nach Anspruch 1, **dadurch gekennzeichnet**, daß die Infrarotlampe (8, 15) eine Infrarotstrahlungsquelle liefert, die am intensivsten in Wellenlängenbereich von 0,75 bis 5 µm ist.

3. Verfahren nach Anspruch 1 oder 2, **dadurch gekennzeichnet**, daß die Infrarotlampe (8, 15) außerhalb der Reaktionskammer (1) angeordnet und so positioniert ist, daß sie Infrarotstrahlung auf den Plättchenhalter (2) über ein infrarottransparentes Fenster (5) richtet, das in einer Wand (1b) der Reaktionskammer direkt gegenüber dem Plättchenhalter (2) angeordnet ist.

4. Verfahren nach Anspruch 3, bei dem ein Infrarotfilter (16) zwischen der äußeren Infrarotlampe (15) und dem Fenster (5) angeordnet ist, wobei ein solches Filter dazu dient, die in die Reaktionskammer (1) und auf das Plättchen (3), das von dem Plättchenhalter (2) getragen wird, gerichtete Infrarotstrahlung auf Wellenlängen im Bereich von 0,75 bis 5 µm zu begrenzen.

5. Verfahren nach Anspruch 1 bis 4, **dadurch gekennzeichnet**, daß das Plättchen (3) zusätzlich durch eine Widerstandsheizeinrichtung (18) erhitzt wird, die in den Plättchenhalter (2) eingearbeitet ist.

6. Verfahren zur selektiven Abscheidung eines Metalles in einem Loch oder in Löchern (9a) auf einem Plättchen (3) darauf vorgesehen durch ein Durchgangsloch oder Durchgangslöcher in einem Isolierfilm (9), der auf der Oberfläche eines Plättchensubstrates (3a) ausgebildet ist, durch chemische Abscheidung aus der Dampfphase in einem Reaktor durch die Stufen, in denen man das Plättchen (3) auf einem Plättchenhalter (2) in einer Reaktionskammer (1) anordnet, die Reaktionskammer evakuiert, in die evakuierte Reaktionskammer und über die Oberfläche des Plättchens ein Reaktionsgasgemisch (R, R') einführt, welches ein metallhaltiges Gas und ein reduzierendes Gas, das mit dem metallhaltigen Gas unter Abscheidung des Metalles in dem Durchgangsloch oder den Durchgangslöchern reagieren kann, enthält, und das Plättchen erhitzt, während es in der Kammer von dem Halter getragen wird, um dabei das Metall im wesentlichen nur in dem Loch oder den Löchern (9a) abzuscheiden, wobei in den Anfangsstufen der Abscheidung die Abscheidung eines dünnen Anfangsfilmes (10) des Metalles direkt auf der Oberfläche des Substrates in dem Durchgangsloch oder den Durchgangslöchern (9a) bewirkt wird und in den anschließenden Stufen der Abscheidung die Abscheidung einer weiteren Schicht (11) des Metalles über der Anfangsabscheidung (10) als ein Ergebnis der Reaktion des metallhaltigen Gases und des reduzierenden Gases in den Löchern bewirkt wird, wobei das gasförmige Reaktionsgemisch (R, R') in die Reaktionskammer (1) in einer Richtung im wesentlichen parallel zu der Oberfläche des Plättchens strömt, um einen im wesentlichen laminaren Fluß von Reaktionsgas über die Oberfläche des Plättchens zu liefern, und wobei eine Inertgasstrom (Q), gegebenenfalls mit einem Gehalt eines teilreaktiven Gases, in die Raktionskammer (1) im wesentlichen senkrecht zu der Richtung des Flusses des Reaktionsgasgemisches (R, R') durch die Kammer und im wesentlichen senkrecht zu dem Plättchenhalter (2) gerichtet wird, um dabei den laminaren Reaktionsgasfluß über das oder die Plättchen (3), die von dem Plättchenhalter (2) getragen werden, und in Berührung mit ihnen aufrechtzuhalten und im wesentlichen eine Diffusion des Reaktionsgemisches aufwärts in der Reaktionskammer zu verhindern.

7. Verfahren nach Anspruch 6, **dadurch gekennzeichnet**, daß das oder die Plättchen (3) mit Hilfe einer Widerstandsheizung (30), die in den Plättchenhalter (2) eingearbeitet ist, erhitzt wird oder werden.

8. Verfahren nach Anspruch 6, **dadurch gekennzeichnet**, daß der Plättchenhalter (2', 2") für Infrarotstrahlung transparent ist und daß das Plättchen mit Hilfe einer Infrarotlampe (8, 15) erhitzt wird, die so angeordnet ist, daß sie Infrarotstrahlung auf das Plättchen durch den Halter hindurch richtet.

9. Verfahren nach Anspruch 8, **dadurch gekennzeichnet**, daß die Infrarotlampe (8) außerhalb der Reaktionskammer (1) und in einer solchen Stellung angeordnet ist, daß sie Infrarotstrahlung auf das Plättchen durch den Halter hindurch und durch ein infrarottransparentes Fenster (5) in der Wand (1c) der Reaktionskammer richtet.

10. Verfahren nach Anspruch 8, **dadurch gekennzeichnet**, daß die Infrarotlampe (8) im Inneren der Reaktionskammer (1) angeordnet ist.

11. Verfahren nach Anspruch 10, **dadurch gekennzeichnet**, daß ein zweiter Inertgasstrom (17) dazu gebracht wird, zwischen der Infrarotlampe (8) und dem Plättchenhalter (2") zu strömen, um die Infrarotlampe (8) gegenüber dem Reaktionsgasgemisch (R, R') abzuschirmen.

12. Verfahren nach einem der vorausgehenden Ansprüche, bei dem das reduzierende Gas H₂ und das metallhaltige Gas eine oder mehrere der Verbindungen WF₆, MoF₆, TaF₅, CrF₄, TiF₄, TiCl₄, MoCl₅, WCl₆ und AlCl₃ ist.

13. Verfahren nach einem der vorausgehenden Ansprüche, bei dem der isolierende Film (9) aus einem oder mehreren der Stoffe SiO₂, Al₂O₃, BSG-, PSG- oder BPSG-Oxiden, BN, SiNₓ oder SiNₓO_{y} besteht.

14. Verfahren nach Anspruch 11, bei dem das Plättchensubstrat (3a) aus einer unteren Trägerschicht (13) mit einem Oberflächenfilm (14) besteht, welche letztere aus darauf abgeschiedenem Silicium besteht und unter der Isolierschicht (9) liegt.

15. Verfahren nach einem der vorausgehenden Ansprüche, bei dem der Plättchenhalter(2) während der chemischen Abscheidung des Metalles auf dem darauf getragenen Plättchen aus der Dampfphase gedreht wird.

## Revendications

1. Procédé pour déposer sélectivement un métal dans un trou ou des trous (9a) sur une plaquette (3), ménagés sur cette dernière par percement(s) débouchant(s) à travers une couche isolante (9) formée sur la surface d'un substrat de plaquette (3a), par dépôt en phase gazeuse par procédé chimique dans un réacteur par les étapes consistant à placer la plaquette (3) sur un support de plaquette (2) dans une chambre de réaction (1), vider la chambre de réaction, amener à la chambre de réaction vidée et en travers de la surface de la plaquette un mélange gazeux de réaction (R, R') contenant un gaz à contenu métallique et un gaz réducteur susceptible de réagir avec le gaz à contenu métallique pour déposer ledit métal dans ledit trou ou lesdits trous, et exposer la plaquette, tandis qu'elle est maintenue dans la chambre sur ledit support, à une source de rayonnement infrarouge de manière à faire en sorte que le métal ne se dépose substantiellement que dans ledit trou ou lesdits trous (9a), dans lequel la source de rayonnement infrarouge est une lampe infrarouge (8, 15), dans les stades initiaux du dépôt ,le dépôt d'une couche mince initiale (10) dudit métal est effectué directement sur la surface du substrat (3a) dans lesdits trous débouchants (9a), et dans les stades suivants du dépôt, ladite lampe entraîne le chauffage préférentiel de cette couche déposée initialement (10) de manière à effectuer le dépôt d'une couche suivante (11) dudit métal au dessus du dépôt initial (10) comme résultat de la réaction du gaz à contenu métallique et du gaz réducteur dans lesdits trous en vertu des différents taux d'absorption infrarouge de ladite couche mince initiale (10) et de la couche isolante environnante (9), et dans lequel, en outre, le mélange gazeux de réaction (R, R') s'écoule dans la chambre de réaction (1) dans une direction substantiellement parallèle à la surface de la plaquette de manière à mettre en oeuvre un écoulement substantiellement laminaire de gaz de réaction en travers de la surface de la plaquette, et dans lequel un courant de gaz inerte (Q), contenant de manière optionnelle un gaz partiellement réactif, est dirigé dans la chambre de réaction (1) substantiellement perpendiculairement à la direction d'écoulement du mélange gazeux de réaction (R, R') à travers la chambre et substantiellement perpendiculairement à la surface du support de plaquette (2) pour maintenir ainsi l'écoulement laminaire de gaz de réaction en travers et au contact de la plaquette ou des plaquettes (3) portées par le support de plaquette (2) et pour empêcher, de manière substantielle, la diffusion du mélange gazeux de réaction vers le haut dans la chambre de réaction.

2. Procédé selon la revendication 1, caractérisé en ce que la lampe infrarouge (8, 15) fournit une source de rayonnement infrarouge qui est le plus intense dans la plage de longueurs d'onde allant de 0.75 à 5 µm.

3. Procédé selon la revendication 1 ou 2, caractérisé en ce que la lampe infrarouge (8, 15) est située à l'extérieur de la chambre de réaction (1) et positionnée pour diriger un rayonnement infrarouge sur le support de plaquette (2) à travers une fenêtre transparente à l'infrarouge (5) se trouvant sur une paroi (1b) de la chambre de réaction directement opposée au support de plaquette (2).

4. Procédé selon la revendication 3, caractérisé en ce qu'un filtre à infrarouge (16) est positionné entre la lampe infrarouge externe (15) et ladite fenêtre (5), un tel filtre servant à restreindre dans une plage de longueurs d'onde allant de 0.75 à 5 µm le rayonnement infrarouge dirigé dans la chambre de réaction (1) et sur la plaquette (3) portée par le support de plaquette (2).

5. Procédé selon les revendications 1 à 4, caractérisé en ce que la plaquette (3) est chauffée de manière additionnelle par un dispositif de chauffage à résistance (18) incorporé dans le support de plaquette (2).

6. Procédé pour déposer sélectivement un métal dans un trou ou des trous (9a) sur une plaquette (3), ménagés sur cette dernière par percement(s) débouchant(s) à travers une couche isolante (9) formée sur la surface d'un substrat de plaquette (3a), par dépôt en phase gazeuse par procédé chimique dans un réacteur par les étapes consistant à placer la plaquette (3) sur un support de plaquette (2) dans une chambre de réaction (1), vider la chambre de réaction, amener à la chambre de réaction vidée et en travers de la surface de la plaquette un mélange gazeux de réaction (R, R') contenant un gaz à contenu métallique et un gaz réducteur susceptible de réagir avec le gaz à contenu métallique pour déposer ledit métal dans ledit trou ou lesdits trous, et chauffer la plaquette, tandis qu'elle est maintenue dans la chambre sur ledit support, de manière à ne déposer substantiellement le métal que dans ledit trou ou lesdits trous (9a), dans lequel, dans les stades initiaux du dépôt, le dépôt d'une couche mince initiale (10) dudit métal est effectué directement sur la surface du substrat dans ledit trou débouchant ou lesdits trous débouchants (9a), et dans les stades suivants du dépôt, le dépôt d'une couche suivante (11) dudit métal au dessus du dépôt initial (10) est effectué comme résultat de la réaction du gaz à contenu métallique et du gaz réducteur dans les trous, dans lequel le mélange gazeux de réaction (R, R') s'écoule dans la chambre de réaction (1) dans une direction substantiellement parallèle à la surface de la plaquette de manière à mettre en oeuvre un écoulement substantiellement laminaire de gaz de réaction en travers de la surface de la plaquette, et dans lequel un courant de gaz inerte (Q), contenant de manière optionnelle un gaz partiellement réactif, est dirigé dans la chambre de réaction (1) substantiellement perpendiculairement à la direction d'écoulement du mélange gazeux de réaction (R, R') à travers la chambre et substantiellement perpendiculairement au support de plaquette (2) pour maintenir ainsi l'écoulement laminaire de gaz de réaction en travers et au contact de la plaquette ou des plaquettes (3) portées par le support de plaquette (2) et pour empêcher, de manière substantielle, la diffusion du mélange gazeux de réaction vers le haut dans la chambre de réaction.

7. Procédé selon la revendication 6, caractérisé en ce que la plaquette ou les plaquettes (3) sont chauffées au moyen d'un chauffage à résistance (30) incorporé dans le support de plaquette (2).

8. Procédé selon la revendication 6, caractérisé en ce que le support de plaquette (2', 2") est transparent au rayonnement infrarouge et en ce que la plaquette est chauffée au moyen d'une lampe infrarouge (8, 15) positionnée de manière à diriger un rayonnement infrarouge sur la plaquette à travers le support.

9. Procédé selon la revendication 8, caractérisé en ce que la lampe infrarouge (8) se trouve à l'extérieur de la chambre de réaction (1) et dans une position pour diriger un rayonnement infrarouge sur la plaquette à travers ledit support et à travers une fenêtre transparente à l'infrarouge (5) dans la paroi (1c) de la chambre de réaction.

10. Procédé selon la revendication 8, caractérisé en ce que la lampe infrarouge (8) est positionnée à l'intérieur de la chambre de réaction (1).

11. Procédé selon la revendication 10, caractérisé en ce que un second courant de gaz inerte (17) est conduit à s'écouler entre la lampe infrarouge (8) et le support de plaquette (2") pour protéger la lampe infrarouge (8) du mélange de gaz de réaction (R, R').

12. Procédé selon l'une quelconque des revendications précédentes, dans lequel ledit gaz réducteur est H₂, et le gaz à contenu métallique est constitué par l'un ou plusieurs des gaz suivants: WF₆, MoF₆, TaF₅, CrF₄, TiF₄, TiCl₄, MoCl₅, Wcl₆ et AlCl₃.

13. Procédé selon l'une quelconque des revendications précédentes, caractérisé en ce que ladite couche isolante (9) est constituée par l'un ou plusieurs des matériaux suivants: SiO₂, Al₂O₃, oxydes de BSG, PSG ou BPSG, BN, SiNₓ, ou SiNₓO_{y}.

14. Procédé selon la revendication 11, dans lequel le substrat de plaquette (3a) consiste en une couche de support inférieure (13) sur laquelle est déposé un film superficiel (14) de silicium qui s'étend sous ladite couche isolante (9).

15. Procédé selon l'une quelconque des revendications précédentes, dans lequel le support de plaquette (2) est mis en rotation pendant le dépôt en phase gazeuse par procédé chimique dudit métal sur la plaquette qu'il porte.
